Europäisches Patentamt

European Patent Office

Office européen des brevets

(11) Numéro de publication : **0 329 518 B1**

(12) **FASCICULE DE BREVET EUROPEEN**

(45) Date de publication du fascicule du brevet :
**24.03.93 Bulletin 93/12**

(51) Int. Cl.$^5$ : **H01L 27/148**

(21) Numéro de dépôt : **89400314.4**

(22) Date de dépôt : **03.02.89**

(54) **Dispositif de lecture de charges pour capteur photosensible linéaire, avec dispositif d'antiéblouissement à structure en ligne.**

(30) Priorité : **12.02.88 FR 8801683**

(43) Date de publication de la demande :
**23.08.89 Bulletin 89/34**

(45) Mention de la délivrance du brevet :
**24.03.93 Bulletin 93/12**

(84) Etats contractants désignés :
**DE FR GB NL**

(56) Documents cités :
**GB-A- 2 125 650**
**US-A- 4 169 273**
**US-A- 4 242 599**
**US-A- 4 644 572**

(56) Documents cités :
**SOLID STATE TECHNOLOGY, vol. 19, no. 9, septembre 1976, pages 83-86, Washington, US; D.D. WEN et al.: "A review of CCD imaging technology"**

(73) Titulaire : **THOMSON-CSF**
**51, Esplanade du Général de Gaulle**
**F-92800 Puteaux (FR)**

(72) Inventeur : **Coutures, Jean-Louis**
**THOMSON-CSF SCPI 19, avenue de Messine**
**F-75008 Paris (FR)**

(74) Mandataire : **Guérin, Michel et al**
**THOMSON-CSF, SCPI, B.P. 329, 50, rue**
**Jean-Pierre Timbaud**
**F-92402 Courbevoie Cédexc (FR)**

**Description**

La présente invention concerne les dispositifs semiconducteurs photosensibles, et plus précisément des barettes linéaires photosensibles constituées d'une ligne de photodiodes couplées à un registre de lecture à transfert de charges.

L'invention concerne plus précisément la structure du dispositif de lecture à transfert de charges et des moyens qui sont associés à ce dispositif pour éviter la saturation du dispositif de lecture en présence d'un éclairement important des barettes.

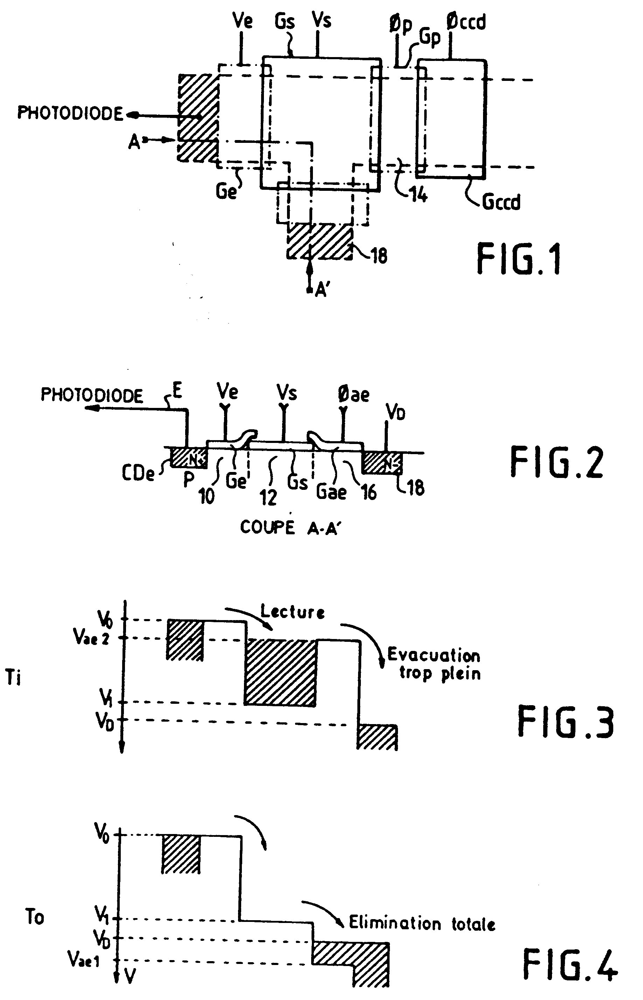

La figure 1 représente en vue de dessus une constitution possible de ce dispositif de lecture pour l'une des photodiodes de la barette. La figure 2 représente une coupe selon la ligne AA' de la figure 1.

La photodiode n'est pas représentée; elle ne fait d'ailleurs pas forcément partie du même substrat semiconducteur que le dispositif de lecture. Elle est reliée, à travers un conducteur d'entrée E, à la cathode CDe d'une diode d'entrée De du dispositif de lecture; la cathode est une région semiconductrice de type N diffusée dans le substrat semiconducteur de type P dans lequel est réalisé le dispositif de lecture.

Une grille d'entrée Ge, isolée du substrat par une couche isolante mince, recouvre une région de substrat 10 de type P immédiatement adjacente à la cathode de la diode d'entrée De. Cette grille est portée à un potentiel constant Ve et permet de fixer le potentiel de la diode De à une valeur Vo.

Une grille de stockage Gs, également isolée du substrat, recouvre une région de substrat 12 de type P immédiatement adjacente à la région 10. Cette grille est portée à un potentiel fixe Vs et permet de stocker les charges en provenance de la photodiode au fur et à mesure qu'elles arrivent de celle-ci par suite de l'exposition de la photodiode à la lumière. Le potentiel du substrat sous la grille Gs en l'absence de charges stockées est V1.

Une grille de passage Gp, isolée du substrat, recouvre une région de substrat 14 immédiatement adjacente à la région 12. Cette grille permet d'isoler la zone de stockage de charges (sous la grille Gs) pendant l'éclairement, et, périodiquement, à la fin d'une période de mesure d'éclairement, elle est portée à un potentiel suffisamment élevé pour transférer les charges stockées vers un registre à décalage à transfert de charges. Ce registre fonctionnera pendant les intervalles entre ces transferts périodiques, pour transmettre une information d'éclairement reçu par la photodiode; le registre à décalage transfère l'information pendant qu'une nouvelle période d'éclairement engendre de nouvelles charges sous la grille de stockage Gs.

Le registre à décalage est schématisé par une électrode de grille Gccd, pilotée par une phase de commande Øccd à la fréquence de fonctionnement propre du registre; cette électrode est adjacente à la grille de passage Gp.

Pour éviter les problèmes d'éblouissement, c'est-à-dire la génération de charges en quantité trop élevée pendant la période de mesure d'éclairement lorsque l'éclairement est trop intense, on prévoit de plus une grille Gae d'évacuation de charges au dessus d'une région de substrat 16 de type P, immédiatement adjacente d'un côté à la région de stockage 12 et de l'autre à une région 18 d'évacuation de charges; cette région est une région de type N (type opposé à celui du substrat) qui est reliée à une source de tension positive Vd.

La grille d'évacuation de charges Gae est utilisée de deux manières:

- d'une part, si on sait que l'éclairement moyen pendant une période va être trop fort (par exemple parcequ'on l'a constaté à la période précédente), on empêche les charges de s'accumuler sous la grille de stockage pendant une fraction de la période de mesure; pour cela, on abaisse la barrière de potentiel engendrée par la grille Gae et toutes les charges amenées par l'entrée E sont aussitôt évacuées vers la région 18. Puis on autorise l'accumulation de charges pendant le reste de la période; la fraction de période correspondant à l'évacuation systématique des charges engendrées est choisie de manière que globalement on ne risque pas de saturer le registre à décalage ;

- d'autre part, en dehors de la période d'évacuation de charges, pendant la période d'intégration proprement dite, si l'éclairement est malgré tout trop intense et risque de conduire à une saturation du registre à décalage, on s'arrange pour que le surplus de charges soit automatiquement évacué vers la région d'évacuation 18. Pour cela on ajuste le potentiel de la grille d'évacuation Gae pendant la période d'intégration à une valeur choisie qui définit le maximum de charges stockables sous la grille Gs. Au-delà les charges se déversent dans la région 18.

Les figures 3 et 4, au dessous de la figure 2, représentent les potentiels dans le substrat sous les différentes grilles, d'une part (figure 3) pendant la période d'intégration proprement dite (grille Gae à un potentiel relativement bas), et d'autre part (figure 4) pendant la fraction de période pendant laquelle on interdit toute accumulation. De manière classique, on représente les potentiels croissants vers le bas, et les zones d'accumulation ou d'évacuation de charges par des zones hachurées.

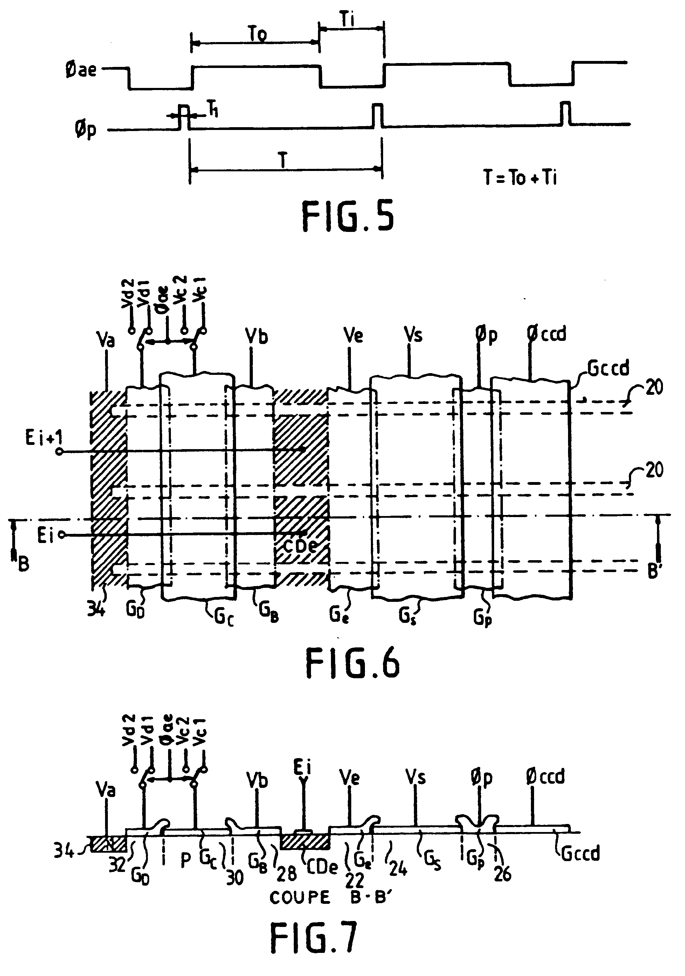

La figure 5 rappelle, pour mémoire, un diagramme temporel des phases de fonctionnement du dispositif: la grille Gae est portée à un potentiel haut pendant une phase d'évacuation de durée To; puis, pendant une phase d'intégration de durée Ti, la grille Gae est portée à un potentiel relativement bas définissant le seuil de trop-plein des charges stockées. A la fin de la durée Ti, avant une nouvelle période To, la grille de passage Gp est brièvement ouverte pendant une durée T1 puis refermée.

La solution qui vient d'être décrite, pour la réalisation de dispositifs de lecture de charges avec évacuation de trop-plein de charges et possibilité d'établir un temps d'intégration variable des charges amenées, présente deux types d'inconvénients; le premier est le fait que la région (18) d'évacuation de charges et la grille Gae qui la sépare de la région de stockage 12 doivent être placées sur un troisième côté de la région 12, un premier côté étant occupé par la grille d'entrée Ge, et un deuxième par la grille de passage Gp. Si on veut réaliser un dispositif de lecture avec de nombreux éléments côte à côte, chaque élément correspondant à une photodiode respective, le pas entre éléments adjacents sera augmenté par la présence de la grille Gae et de la région 18 sur le troisième côté de la grille 12, ainsi que des connexions d'amenée de signaux de commande à cette grille et à cette région.

Le deuxième inconvénient est le fait que l'effet d'antiéblouissement n'a pas lieu pendant le temps T1 de transfert des charges de la grille de stockage vers le registre à décalage de lecture. Si le temps T1 n'est pas négligeable devant la durée Ti d'intégration effective, et si l'éclairement est très intense pendant le temps T1, une charge correspondante sera introduite dans le registre à décalage pendant le temps T1 de transfert, et cette charge pourra être suffisante pour saturer le registre malgré la présence de l'ensemble du système d'antiéblouissement.

Pour remédier aux inconvénients de la technique précédemment décrite, la présente invention propose une nouvelle structure de dispositif de lecture de charges pour photosenseur linéaire comportant un dispositif d'antiéblouissement.

Le dispositif de lecture comporte une diode d'entrée, une grille de stockage de charges recouvrant une région de stockage de charges, une grille d'entrée recouvrant une région d'entrée intercalée entre un premier côté de la diode d'entrée et la région de stockage de charges, et une grille de passage recouvrant une région adjacente à la région de stockage de charges et séparant cette dernière d'un registre de lecture à transfert de charges; selon l'invention, il est prévu une première région de substrat recouverte par une première grille portée à un potentiel constant, tel que le potentiel dans la première région en l'absence de charges soit supérieur au potentiel dans la région d'entrée en l'absence de charges, la première région étant adjacente à un deuxième côté de la diode d'entrée, opposé au premier côté, une deuxième région de substrat adjacente à la première région et recouverte par au moins une deuxième grille, et une région d'évacuation de charges adjacente à la deuxième région de substrat, la deuxième grille étant portée à des potentiels variant cycliquement selon deux phases qui sont

- une phase d'évacuation dans laquelle le potentiel imposé par la deuxième grille dans la deuxième région est supérieur au potentiel de la première région,
- une phase d'intégration dans laquelle le potentiel imposé par la deuxième grille dans la deuxième région est inférieur au potentiel de la première région et inférieur au potentiel dans la région d'entrée, le potentiel de la grille de passage étant porté pendant un bref instant commençant après le début de la phase d'évacuation à une valeur haute permettant le transfert de charges de la région de stockage vers le registre de lecture, et ce potentiel étant maintenu à une valeur basse pendant la totalité de la phase d'intégration.

Avec cette structure, il est maintenant possible de réaliser une évacuation de charges, soit pour le déversement d'un trop-plein de charges, soit pour la commande du temps d'intégration effectif, sans utiliser le troisième côté de la grille de stockage comme c'était le cas à la figure 1.

De plus, comme le transfert vers le registre de lecture des quantités de charges accumulées sous la grille de stockage peut maintenant se faire en dehors du temps d'intégration effective, on montrera qu'il n'y a plus le risque mentionné précédemment de saturation du registre par suréclairement pendant le temps de transfert.

Dans une réalisation préférentielle, le dispositif comporte une troisième grille recouvrant une troisième région constituée par une portion de la deuxième région, la troisième région étant adjacente à la région d'évacuation; le potentiel de la troisième grille varie cycliquement selon les deux phases de fonctionnement du dispositif, et le potentiel engendré en l'absence de charges sous la deuxième grille pendant la phase d'évacuation est supérieur au potentiel engendré sous la troisième grille.

D'autres caractéristiques et avantages de l'invention apparaîtront à la lecture de la description détaillée qui suit et qui est faite en référence aux dessins annexés dans lesquels:

- les figures 1 à 5 déjà décrites permettent de comprendre le fonctionnement d'un dispositif de lecture de charges avec dispositif d'antiéblouissement classique;
- la figure 6 représente une vue de dessus d'un dispositif de lecture selon la présente invention;
- la figure 7 représente une coupe transversale de la structure de la figure 6,
- la figure 8 représente le profil des potentiels dans le substrat semiconducteur pendant une phase d'intégration effective des charges générées par le photosenseur,
- la figure 9 représente le profil des potentiels dans le substrat pendant une phase d'évacuation systématique des charges engendrées,
- la figure 10 représente un diagramme temporel des phases relatives d'application de potentiels choisis aux grilles du dispositif de lecture.

- la figure 11 représente le profil de potentiels pendant la phase d'intégration en présence d'un suréclairement.

A la figure 6, on voit en vue de dessus deux éléments juxtaposés du dispositif de lecture selon l'invention; chaque élément correspond à la lecture des charges engendrées par une photodiode respective du photosenseur linéaire, et on a représenté deux éléments pour bien montrer comment il est possible de disposer côte-à-côte, régulièrement et avec un pas aussi faible que possible, toute une ligne d'éléments de lecture.

Les éléments de lecture sont isolés les uns des autres par un moyen quelconque qui peut être par exemple une zone isolante relativement épaisse s'étendant le long de deux éléments à séparer; de telles zones sont représentées par les lignes tiretées 20 de la figure 6.

Cet isolement est réalisé pour séparer les unes des autres les zones de substrat semiconducteur qui sont proches les unes des autres mais qui correspondent à des éléments de lecture différents; mais il n'est pas nécessaire de réaliser un isolement entre deux grilles correspondant à des éléments de lecture différents si ces grilles doivent être reliées à chaque instant à un même potentiel constant ou variable. C'est pourquoi on verra que les grilles du dispositif de lecture selon l'invention s'étendent toutes perpendiculairement aux zones d'isolement 20 et recouvrent des régions correspondantes de tous les éléments de lecture juxtaposés. Par exemple la grille de stockage qui joue le rôle expliqué en référence aux figures 1 à 5 est une grille unique qui recouvre des régions de substrat isolées les unes des autres par des zones 20.

On va décrire la constitution d'un élément de lecture de rang i, la structure des éléments voisins de rang i-1 et i+1 étant exactement la même et étant recouverte par les grilles qui recouvrent l'élément de rang i.

La description sera faite en référence à la figure 6 qui est une vue de dessus et à la figure 7 qui est une coupe transversale selon la longueur de l'élément de lecture de rang i (coupe selon la ligne BB' de la figure 6).

L'élément de lecture de rang i comporte une entrée Ei reliée à une cellule photosensible élémentaire (photodiode) respective de rang i du photosenseur linéaire dont on veut mesurer le signal de sortie.

Les cellules photosensibles ne sont pas représentées et ne font d'ailleurs pas forcément partie du même substrat semiconducteur que le dispositif de lecture, surtout s'il s'agit d'un détecteur fonctionnant en infrarouge car alors il faut utiliser pour le photosenseur et pour le dispositif de lecture des substrats différents.

L'entrée Ei est reliée à la cathode CDe d'une diode d'entrée De; on a donné à cette diode la même référence qu'à la figure 1 car elle joue le même rôle. La cathode de la diode est une région de type N diffusée superficiellement dans le substrat semiconducteur qui est de préférence de type P ; les dopages P et N pourront être inversés à condition d'inverser aussi les signes des potentiels.

La diode d'entrée est adjacente d'un premier côté à une région 22 de type P, recouverte par une grille d'entrée Ge portée à un potentiel Ve fixe. Cette grille d'entrée Ge a pour fonction de maintenir le potentiel de la région 22 à une valeur Vo fixe.

De même qu'à la figure 1, on trouve ensuite une région 24 de stockage de charges, adjacente à la région 22 et recouverte par une grille de stockage Gs portée à un potentiel fixe Vs.

Il est prévu ensuite une région 26 adjacente à la région 24 et recouverte par une grille de passage Gp, commandée par une phase Øp de sorte que pendant l'état haut de Øp le potentiel de la grille Gp est monté à une valeur qui permet le transfert de toutes les charges stockées sous la grille de stockage vers un registre à décalage; ce registre est schématisé sur les figures 6 et 7 par une électrode de grille Gccd commandée par une phase Øccd. Les régions 22, 24, 26 du substrat semiconducteur se situent, comme on le voit sur les figures 6 et 7, d'un premier côté de la diode d'entrée De, la région 24 étant plus éloignée que la région 22 et la région 26 plus éloignée que la région 24.

De l'autre côté de la diode d'entrée, sur la gauche des figures 6 et 7, on trouve une succession de trois grilles recouvrant des régions successives de type P du substrat.

La première grille Gb recouvre une région 28 immédiatement adjacente à la diode d'entrée; cette première grille Gb est portée à un potentiel constant Vb tel que le potentiel de la région 28 en l'absence de charges stockées dans cette région ait une valeur V1 proche du potentiel Vo de la région 22 située sous la grille d'entrée Ge et de préférence supérieure à ce potentiel.

La deuxième grille Gc recouvre une région 30 adjacente à la région 28 et elle est connectée à un potentiel variant cycliquement selon deux phases: dans une première phase, le potentiel Vc1 appliqué à la deuxième grille Gc est relativement élevé et induit sous cette grille un potentiel V3 nettement supérieur au potentiel V1 sous la première grille Gb, de sorte que toutes les charges qui pouvaient être stockées sous la première grille se déversent sous la deuxième; on reviendra plus loin sur le rôle de ce déversement; dans une deuxième phase, le potentiel Vc2 appliqué à la deuxième grille est relativement bas et tel que le potentiel de la région 30 soit inférieur non seulement au potentiel V1, mais aussi au potentiel Vo sous la grille d'entrée de l'autre côté de la diode d'entrée De.

La troisième grille Gd recouvre une région 32 adjacente à la région 30 et elle est connectée à une source de tension variant en phase avec la commande de la deuxième grille; les potentiels Vd1 et Vd2 appliqués à la troisième grille sont tels que le potentiel de la région 32 soit toujours inférieur au potentiel dans la région 30; dans la première phase, on donne au potentiel de la région 32 une valeur haute V2 comprise entre V1 et V3; dans la deuxième phase, on lui donne une valeur basse VL inférieure au potentiel de la région 30 donc inférieure aussi au potentiel Vo sous la grille d'entrée et supérieure au potentiel Vp sous le grille Gp pendant la même phase.

Enfin, on voit encore sur les figures 6 et 7 une région d'évacuation de charges 34, sous forme d'une région de type N diffusée dans le substrat P. Cette région est adjacente à la région 32 recouverte par la troisième grille, et elle est portée à un potentiel Va relativement élevé, qui peut être constant, et qui doit être, pendant la première phase, supérieur au potentiel V2 sous la troisième grille Gd.

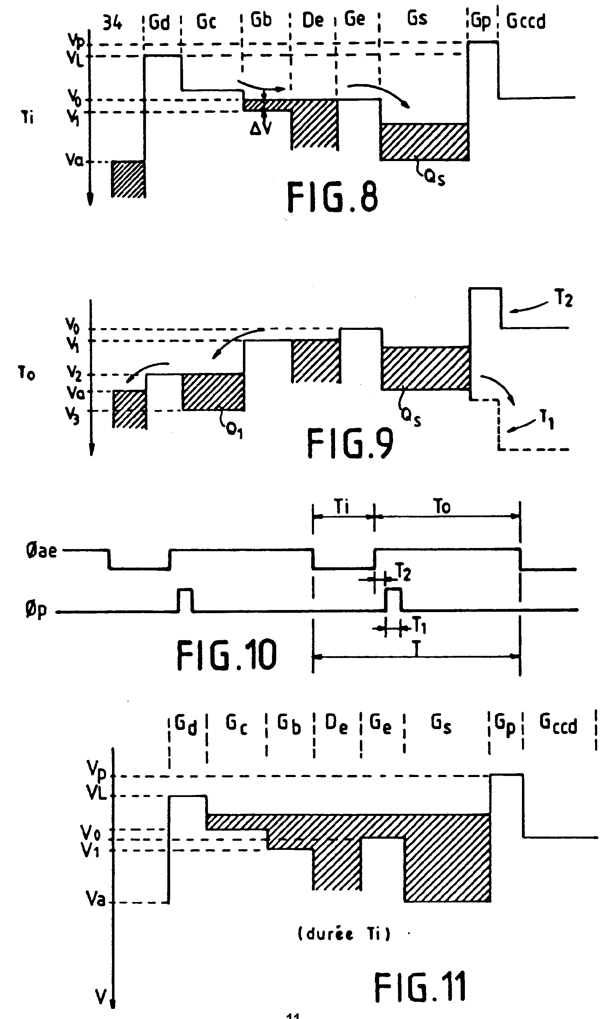

En référence aux figures 8, 9 et 10, on va maintenant décrire le fonctionnement de ce dispositif de lecture.

Comme dans le dispositif de la figure 1, le fonctionnement se déroule en une première phase d'évacuation systématique des charges amenées sur l'entrée, pour empêcher le stockage de ces charges sous la grille Gs, et une deuxième phase d'intégration pendant laquelle l'accumulation de charges sous la grille Gs est autorisée; la première phase dure un temps To qui peut être une fraction variable de la période T de fonctionnement du dispositif; la deuxième phase occupe le reste Ti du temps T. Sur les figures un signal logique périodique Øae définit ces deux phases à chaque période; le déversement vers le registre à décalage des charges stockées sous la grille a lieu pendant un bref instant, de durée T1, à chaque période T; la durée T1 commence après un léger retard T2 suivant le début de la phase d'évacuation To. Le déversement est commandé par la grille de passage Gp à partir d'un signal logique Øp définissant le retard T2 et la durée T1. Les signaux logiques Øae et Øp sont rappelés sur la figure 10.

La figure 8 représente un diagramme des potentiels dans le substrat sous les différents éléments (grilles et diodes) de la figure 7, pendant la phase d'intégration de charges reçues de la photodiode, en supposant qu'il n'y a pas de suréclairement justifiant une évacuation d'un trop-plein de charges.

Le potentiel maximum autorisé sous la diode d'entrée et sous la première grille Gb est le potentiel Vo; dès que ce potentiel est dépassé par suite de l'accumulation de charges en provenance de l'entrée Ei (et on verra que cela se produit très rapidement ou même instantanément après le début du temps Ti), les charges arrivant de l'entrée sont déversées vers la région 24 sous la grille de stockage Gs; elles s'accumulent sous cette grille et font descendre le potentiel de la région 24 en proportion de la quantité de charges Qs arrivée. On supposera d'abord que, compte-tenu du potentiel Vs appliqué sur la grille de stockage et de la quantité normale de charges arrivées pendant le temps Ti, le potentiel de la région de stockage 24 ne descend pas au dessous de Vo. Le potentiel Vo définit d'ailleurs le seuil d'éblouissement: si la quantité de charges arrivées pendant la durée Ti fait descendre le potentiel au dessous de Vo, on considère qu'il y a trop de charges et que le surplus doit être évacué pour ne pas risquer une saturation du registre à décalage. On verra plus loin comment se fait cette évacuation.

On aboutit donc, à la fin de la durée Ti, à la configuration de potentiels de la figure 8. Il faut remarquer sur cette figure les charges stockées à la fois dans la diode d'entrée De et sous la première grille, charges qui ont été accumulées au tout début de la période Ti et qui vont se vider dans un puits de potentiel sous la deuxième grille Gc au tout début de la phase d'évacuation qui suit la fin de la phase d'intégration.

La configuration de potentiels pendant la phase d'évacuation To est représentée à la figure 9.

Les charges accumulées sous la première grille et dans la diode d'entrée De se vident dans le puits de potentiel constitué sous la deuxième grille Gc dans la région 30 (dont le potentiel initial en l'absence de charges est V3 plus élevé que les potentiels V2 et V1 des régions 32 et 28 qui l'encadrent). Si les charges transférées sont en quantité Qo plus élevée que ne peut en contenir ce puits, alors le surplus se vide dans la région d'évacuation 34. Le puits de potentiel sous la grille constitue une réserve de charges qui seront replacées sous la première grille Gb et dans la diode d'entrée De au début de la phase d'intégration suivante.

En principe, la capacité de stockage Q1 du puits de potentiel sous la deuxième grille sera choisie inférieure à la quantité de charges Qo stockées entre les potentiels Vo et V1 sous la première grille et dans la diode d'entrée, c'est-à-dire inférieure au produit de la différence V1-Vo par la somme des capacités de la première grille et de la diode. Mais dans certaines applications on pourrait envisager qu'elle soit égale ou supérieure.

Pendant la durée T2, les charges Qs stockées sous la grille de stockage Gs restent confinées dans le puits de potentiel créé sous cette grille; puis la grille de passage Gp est portée pendant la durée T1 à un potentiel élevé qui permet le transfert intégral de la quantité de charges Qs vers le registre à décalage.

Pendant tout le reste de la durée To, la configuration de potentiels de la figure 9 subsiste sans changement, et toutes les charges apportées par l'entrée Ei sont déversées au fur et à mesure qu'elles arrivent vers la région 28, d'où elles passent à la région 30; mais comme le puits de potentiel de la région 30 est plein depuis le tout début de la durée To, les charges supplémentaires se déversent aussitôt dans la région d'évacuation 34; des deux barrières de potentiel encadrant le puits, la barrière est en effet plus basse du côté de la troisième grille.

Par conséquent la structure de la figure 6 permet bien une évacuation totale de charges pendant une fraction choisie de la période de fonctionnement du dispositif.

On va maintenant montrer ce qui se passe en présence d'un éclairement trop intense conduisant à une accumulation trop forte de charges en provenance de la photodiode. Comme on l'a déjà dit, le seuil de quantité de charges admissible peut être réglé par le choix de la capacité de stockage de la région 24 sous la grille Gs. Cette capacité dépend essentiellement de la surface de la grille et de la différence entre le potentiel $V_0$ et le potentiel imposé par la tension $V_s$ dans la région 24 lorsqu'elle est vide de charges.

Pendant la phase d'intégration (figure 11), si les charges s'accumulent au delà de la capacité de stockage du puits de potentiel sous la grille de stockage Gs, alors ces charges débordent dans la diode d'entrée et sous la première grille Gb; si l'accumulation continue, elles débordent aussi sous la grille Gc; on peut même imaginer qu'elle continue au delà des capacités de stockage entre les barrières de potentiel constituées d'une part sous la troisième grille Gd et d'autre part sous la grille de passage Gp; mais alors il faut impérativement prévoir que la barrière de potentiel sous la grille de passage est plus haute que sous la grille Gd; dans ce cas, en cas d'accumulation extrêmement forte, les charges en excès finiront par se déverser dans la région d'évacuation 34.

La figure 11 représente un cas plus probable dans lequel l'accumulation de charges trop grande provoque un débordement allant jusque sous la deuxième grille Gc mais pas plus loin.

Au moment où se termine la durée d'intégration Ti, les barrières de potentiel sous les deuxième et troisième grilles sont simultanément abaissées de sorte que toutes les charges en excès sont vidées dans la région d'évacuation 34 et que seules subsistent des charges dans les puits de potentiel tels qu'ils sont représentés à la figure 9, c'est-à-dire des charges remplissant intégralement le puits créé sous la grille de stockage Gs et des charges remplissant le puits sous la deuxième grille Gc. Seules les charges sous la grille de stockage seront déversées un peu plus tard, pendant la durée T1, et le seuil d'éblouissement ne sera pas dépassé.

Un point important sur lequel il faut revenir est la récupération de la charge $Q_1$ stockée pendant la phase d'évacuation (figure 9) sous la deuxième grille Gc. Lorsque recommence une nouvelle durée d'intégration Ti, les potentiels des deuxième et troisième grilles s'abaissent simultanément, le potentiel de la deuxième restant plus haut que celui de la troisième, et la charge $Q_1$ est déversée vers la première grille Gb.

En principe, cette charge $Q_1$ est inférieure à la charge $Q_0$ qui peut être stockée entre les potentiels $V_0$ et $V_1$ dans la diode De et sous la première grille Gb; cela veut dire que:

- à l'instant où commence la durée Ti, le potentiel de la diode d'entrée et celui de la région 28 sous la première grille descendent à une valeur intermédiaire entre $V_1$ et $V_0$,
- pendant le début de la durée Ti, les premières charges arrivant de l'entrée Ei serviront à faire descendre le potentiel de la diode d'entrée jusqu'à $V_0$,
- et ce n'est qu'après l'arrivée d'une certaine quantité de charges bien déterminée que les charges en provenance de l'entrée pourront être dirigées vers la grille de stockage Gs.

Cette disposition est particulièrement intéressante car elle permet, par un choix approprié de la capacité de stockage sous la grille Gc (fonction de sa surface et de la différence de potentiel $V_3-V_2$), de compenser l'introduction à l'entrée Ei de charges parasites qui ne seraient pas engendrées par l'éclairement que l'on veut mesurer.

Notamment, on sait que les photodiodes engendrent un certain courant, dit "courant d'obscurité" même lorsqu'elles ne sont pas éclairées; le courant de polarisation des photodiodes engendre aussi des charges; la présence de la charge $Q_1$ permet de compenser d'une manière calculable ce courant; on peut très bien envisager que la différence de potentiel $V_3-V_2$ soit asservie sur un paramètre de fonctionnement du dispositif, et notamment sur la durée Ti puisque les effets du courant d'obscurité, ou de toute composante de courant continu parasite, sur la charge Qs seront proportionnels à la durée Ti.

Pour conclure, on rappelle qu'avec la structure selon l'invention, on peut transférer la charge stockée Qs vers le registre à décalage après le début de la phase d'évacuation, de sorte qu'un suréclairement important pendant la durée de transfert T1 n'entraînera pas de charges en excès vers le registre ; au contraire elles seront directement évacuées vers la région 34.

Dans une variante de réalisation, la troisième grille Gd est supprimée et la deuxième grille Gc recouvre une deuxième région regroupant les régions 30 et 32, les dopages du substrat étant différents dans la région 30 et la région 32 de manière à imposer des potentiels $V_2$ et $V_3$ différents pour un potentiel unique appliqué à la grille Gc.

## Revendications

1. Dispositif de lecture de charges pour capteur photosensible linéaire, comportant un substrat semi-conducteur, une diode d'entrée (De), une grille de stockage de charges (Gs) recouvrant une région de stockage de charges (24), une grille d'entrée (Ge) recouvrant une région d'entrée (22) intercalée entre un premier côté de la diode d'entrée et la région de stockage de charges, une grille de passage (Gp) recouvrant une région (26) adjacente à la région de stockage de charges et séparant cette dernière d'un registre de lecture à transfert de charges, une première région de substrat (28) recouverte par une première grille (Gb) portée à un potentiel constant tel que le potentiel (V1) dans la première région en l'absence de charges soit supérieur au potentiel (Vo) dans la région d'entrée en l'absence de charges, la première région étant adjacente à un deuxième côté de la diode d'entrée, opposé an premier côté, une deuxième région de substrat (30, 32) adjacente à la première région et recouverte par au moins une deuxième grille (Gc, Gd), et une région d'évacuation de charges (34) adjacente à la deuxième région de substrat, la deuxième grille étant portée à des potentiels variant cycliquement selon deux phases qui sont

- une phase d'évacuation (To) dans laquelle le potentiel imposé par la deuxième grille dans la deuxième région est supérieur au potentiel de la première région,
- une phase d'intégration (Ti) dans laquelle le potentiel imposé par la deuxième grille dans la deuxième région est inférieur au potentiel de la première région et inférieur au potentiel dans la région d'entrée,

le potentiel de la grille de passage (Gp) étant porté pendant un bref instant (T1) commençant après le début de la phase d'évacuation, à une valeur haute permettant le transfert de charges de la région de stockage vers le registre de lecture, et ce potentiel étant maintenu à une valeur basse pendant la totalité de la phase d'intégration.

2. Dispositif de lecture selon la revendication 1, caractérisé en ce qu'il comporte une troisième grille (Gd) au dessus d'une troisième région (32) constituée par une portion de la deuxième région, adjacente à la région d'évacuation, la troisième grille étant portée à un potentiel variant cycliquement selon les deux phases de fonctionnement du dispositif, de telle manière que le potentiel (V3) qui serait engendré sous la deuxième grille en l'absence de charges pendant la phase d'évacuation soit supérieur au potentiel (V2) sous la troisième grille.

3. Dispositif selon la revendication 2, caractérisé en ce que les potentiels appliqués aux deuxième et troisième grilles pendant la phase d'évacuation définissent un puits de stockage de charges susceptible de stocker une quantité de charges inférieure à une quantité de charges Qo, avec

$$Qo = (V1 - Vo) Cd$$

V1 et Vo étant les potentiels imposés en l'absence de charges sous la première grille et sous la grille d'entrée respectivement durant la phase d'intégration, et Cd étant la somme des capacités de la diode et de la première grille.

**Patentansprüche**

1. Ladungs-Lesevorrichtung für eine lineare lichtempfindliche Sonde mit einem Halbleitersubstrat, einer Eingangsdiode (De), einem Ladungsspeichergate (Gs), das einen Ladungsspeicherbereich (24) überdeckt, einem Eingangsgate (Ge), das einen zwischen eine erste Seite der Eingangsdiode und den Ladungsspeicherbereich eingefügten Eingangsbereich (22) überdeckt, einem Durchgangsgate (Gp), das einen Bereich (26) neben dem Ladungsspeicherbereich bedeckt und diesen Bereich gegen ein Ladungstransfer-Leseregister isoliert, mit einem ersten Substratbereich (28), der mit einem ersten Gate (Gb) bedeckt ist, das auf einen konstanten Potential liegt, derart, daß das Potential (V1) in dem ersten Bereich in Abwesenheit von Ladungen größer als das Potential (Vo) im Eingangsbereich in Abwesenheit von Ladungen ist, wobei der erste Bereich einer zweiten Seite der Eingangsdiode benachbart ist, die der ersten Seite gegenüberliegt, mit einem zweiten Substratbereich (30, 32), der neben dem ersten Bereich liegt und von mindestens einem zweiten Gate (Gc, Gd) bedeckt ist, und mit einem Ladungsabfuhrbereich (34), der dem zweiten Substratbereich benachbart ist, wobei das zweite Gate auf zyklisch variable Potential gebracht wird gemäß zwei Phasen, nämlich

- einer Abfuhrphase (To), in der das vom zweiten Gate im zweiten Bereich aufgeprägte Potential größer als das Potential im ersten Bereich ist,
- einer Integrationsphase (Ti), in der das von dem zweiten Gate in dem zweiten Bereich aufgeprägte Potential geringer als das Potential des ersten Bereichs und geringer als das Potential im Eingangsbereich ist, wobei das Potential des Durchgangsgates (Gp) während eines kurzen Augenblicks (T1) bei Beginn der Abfuhrphase einen hohen Wert annimmt, so daß Ladungen aus dem Speicherbereich in das Leseregister übertragen werden können, und wobei dieses Potential während der gesamten Integrationsphase auf niedrigem Wert gehalten wird.

2. Lesevorrichtung nach Anspruch 1, dadurch gekennzeichnet, daß sie ein drittes Gate (Gd) oberhalb eines zweiten Bereichs (32) besitzt, der durch einen Teil des zweiten Bereichs neben dem Abfuhrbereich gebildet wird, wobei das dritte Gate auf ein zyklisch gemäß zwei Betriebsphasen der Vorrichtung variables Potential gebracht wird, derart, daß das Potential (V3), das unter dem zweiten Gate in Abwesenheit von Ladungen während der Abfuhrphase erzeugt würde, höher als das Potential (V2) des dritten Gates ist.

3. Vorrichtung nach Anspruch 2, dadurch gekennzeichnet, daß die an das zweite und das dritte Gate während der Abfuhrphase angelegten Potentiale eine Ladungsspeichersenke definieren, die eine Ladungsmenge speichern kann, welche geringer als die Ladungsmenge Qo ist, mit

$$Qo = (V1 - Vo)Cd$$

wobei V1 und Vo die während der Integrationsphase in Abwesenheit von Ladungen an dem ersten Gate bzw. unter dem Eingangsgate herrschenden Potentiale und Cd die Summe der Kapazitäten der Diode und des ersten Gates sind.

**Claims**

1. Charge read-out device for linear photosensitive sensor, including a semiconductor substrate, an input diode (De), a charge-storage gate (Gs) covering a charge-storage region (24), an input gate (Ge) covering an input region (22) intercalated between a first side of the input diode and the charge-storage region, a transition gate (Gp) covering a region (26) adjacent to the charge-storage region and separating the latter from a charge-transfer read-out register, a first substrate region (28) covered by a first gate (Gb) carried to a constant potential such that the potential (V1) in the first region in the absence of charges is greater than the potential (Vo) in the input region in the absence of charges, the first region being adjacent to a second side of the input diode, opposite the first side, a second substrate region (30, 32) adjacent to the first region and covered by at least a second gate (Gc, Gd), and a charge-removal region (34) adjacent to the second substrate region, the second gate being carried to potentials varying cyclically according to two phases which are
   - a removal phase (To) in which the potential imposed by the second gate in the second region is greater than the potential of the first region,
   - an integration phase (Ti) in which the potential imposed by the second gate in the second region is less than the potential of the first region and less than the potential in the input region,

the potential of the transition gate (Gp) being carried, for a brief instant (T1) commencing after the start of the removal phase, to a high value enabling charges to be transferred from the storage region to the read-out register, and this potential being held at a low value throughout the integration phase.

2. Read-out device according to Claim 1, characterised in that it includes a third gate (Gd) above a third region (32) consisting of a portion of the second region, adjacent to the removal region, the third gate being carried to a potential varying cyclically according to the two operating phases of the device, in such a way that the potential (V3) which would be engendered beneath the second gate in the absence of charges during the removal phase is greater than the potential (V2) beneath the third gate.

3. Device according to Claim 2, characterised in that the potentials applied to the second and third gates during the removal phase define a charge-storage well capable of storing a quantity of charges which is less than a quantity of charges Qo, with

$$Qo = (V1 - Vo)Cd$$

V1 and Vo being the potentials imposed in the absence of charges beneath the first gate and beneath the input gate respectively during the integration phase, and Cd being the sum of the capacitances of the diode and of the first gate.

FIG.1

COUPE A-A'

FIG.2

FIG.3

FIG.4

$T_0$

$T_i$

Øae

$T_1$

Øp

T

$T = T_0 + T_i$

## FIG.5

Vd 2
Vd 1
Øae
Vc 2
Vc 1

Va

Vb

Ve

Vs

Øp

Øccd

Gccd

20

E i+1

20

CDe

Ei

B

B'

34

$G_D$

$G_c$

$G_B$

$G_e$

$G_s$

$G_p$

## FIG.6

Vd 2
Vd 1
Øae
Vc 2
Vc 1

Va

Vb

Ei

Ve

Vs

Øp

Øccd

34

32

$G_D$

P

$G_c$

30

$G_B$

28

CDe

22

$G_e$

24

$G_s$

$G_p$

26

Gccd

COUPE   B - B'

## FIG.7

FIG.8

FIG.9

FIG.10

FIG.11

(durée Ti)